# EUROPEAN PATENT APPLICATION

(11) **EP 1 602 934 A1**
(43) Date of publication of application: **07.12.2005**
(21) Application number: 04102624.6
(22) Date of filing: 09.06.2004
(51) Int. Cl.: G01R 31/26, G01R 31/316, H01L 31/042

(54) **Sensor device for monitoring the operation of a PV system, and PV system with such a sensor device**

(30) Priority: 04.06.2004 EP 04102544
(71) Applicant: Oldenkamp, Hendrik, 5611 DA Eindhoven (NL)
(72) Inventor: Oldenkamp, Hendrik, 5611 DA Eindhoven (NL)
(74) Representative: de Vries, Johannes Hendrik Fokke

(57) **Abstract**

A sensor device (5) for monitoring the operation of a PV system is described. Such a PV system has at least one PV module (1) with a plurality of PV cells (3) laminated on a support plate (2). The sensor device (5) comprises a substrate (6) with an electronic circuitry (9) adapted to be mounted on the support plate adjacent to PV cells of the PV module. The circuitry comprises two or more input terminals (7,8) for receiving an output voltage of a series connection of one or more PV cells of a PV module, and a comparator (T₁,T₂) for comparing the output voltage received on the input terminals with a first reference voltage corresponding with a first operation level of the PV module. The comparator controls a first signalling element (12) for signalling the operation of the PV module above said first operation level.

## Description

The invention relates to a sensor device for monitoring the operation of a PV (photo voltaic) system, said PV system having at least one PV module with a plurality of PV cells laminated on a support plate, and to a PV system with such a sensor device.

More and more grid-connected PV systems are being installed and many efforts are being made to further improve the efficiency of PV systems. By further improving the efficiency of PV systems it is expected that in the near future kWh costs of PV systems will be acceptable. However, focus should not only be on PV cell efficiency and cost reduction of the components used in a PV system, but also on the proper design and installation of PV systems. Further, also the inverter, i.e. the electrical interface between the PV modules of the system and the utility grid, should have a good maximum power point tracking function.

Practice has shown that even a well-designed PV system may not perform optimal, caused by minor mistakes during installation. Usually several measurements are performed after completion of the installation to ensure a proper operation of the PV system. In practice however a 100% check appears hard to be performed. Many cases are known from practice showing that after a year of operation the yield of a PV system appeared to be much lower than expected. The lower yield of the PV system can be caused for example by mistakes in the wiring between the PV modules of the system, failure of the connectors or wiring, failure in the laminates, failure of by-pass diodes, malfunction of the maximum power point tracking of the inverter and/or extreme pollution or unexpected shading.

In the prior art proposals have been made for a sensor device for monitoring the operation of a PV module, such as for example in US-A-6 107 998. This prior art sensor device is only able to signal an optimal orientation of the PV module with respect to an energizing light source. The sensor device is provided with a separate PV cell so that the sensor device can not indicate the proper operation of the PV module. This document further describes a maximum power tracker having an output which is switched on and off depending on the output voltage of the PV module to ensure operation at its optimum operating voltage.

The invention aims to provide a sensor device of the above mentioned type which can be manufactured at low cost and which can be integrated in a PV module of a PV system, wherein the sensor device provides an efficient signalling of the actual performance of the PV module.

To this end the sensor device according to the invention is characterized by a substrate with an electronic circuitry adapted to be mounted on the support plate adjacent to PV cells of the PV module, said circuitry comprising two or more input terminals for receiving an output voltage of a series connection of one or more PV cells of a PV module, and a comparator for comparing the output voltage received on the input terminals with a first reference voltage corresponding with a first operation level of the PV module, the comparator controlling a first signalling element for signalling the operation of the PV module above said first operation level.

In this manner a sensor device is provided which can be integrated in a PV module and which comprises low cost electronic circuitry with a comparator which controls a signalling element, preferably a visual signalling element so that no expertise is required to check the proper operation of the PV module, i.e. an operation above the first operation level which can easily be set by means of the first reference voltage. During operation periodical checks can be executed by the owner of the PV system. Poor operation of the PV system including poor inverter operation is detected immediately without the need of skilled persons to check the proper operation of the PV system. The invention is based on the insight that it is possible to measure operation of a PV module in an optimal power output range by measuring the output voltage of all or a part of the PV cells of the module in combination with the cell temperature and preferably the irradiation of the cell.

The invention further provides a PV system, comprising at least one PV module with a number of series connected PV cells, wherein said at least one PV module is provided with a sensor device according to the invention.

The invention will be further explained by reference to the drawings in which two embodiments of the sensor device of the invention are schematically shown.

Fig. 1 shows a top view of a PV module comprising an embodiment of the sensor device of the invention.

Fig. 2 is a perspective view of the embodiment of the sensor device used in the PV module of Fig. 1.

Fig. 3 shows a detail of the PV module of Fig. 1 at a larger scale.

Fig. 4 shows the back side of the detail of the PV module of Fig. 3.

Figs. 5-8 show a plurality of graphs used to explain the operation of the sensor device of the invention.

Fig. 9 shows a circuit diagram of an embodiment of the sensor device of the invention.

Fig. 10 shows a circuit diagram of a further embodiment of the sensor device according to the invention.

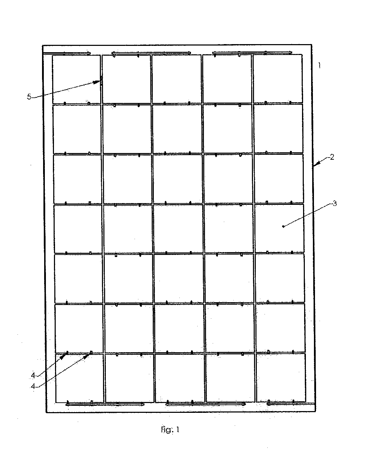

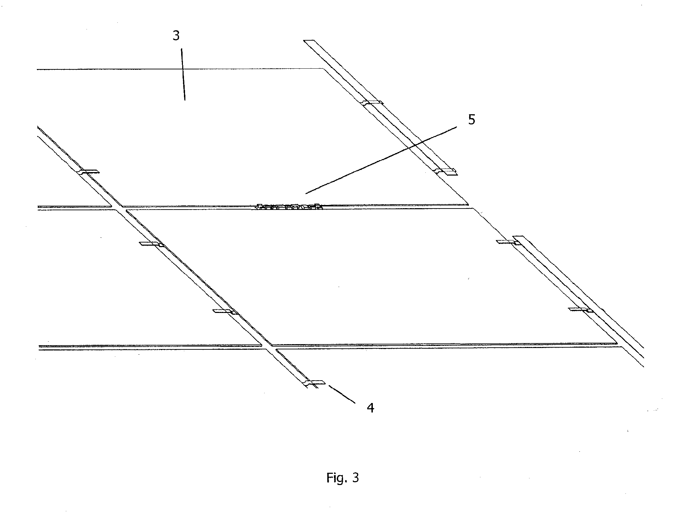

Referring to Fig. 1 there is shown a top view of a photo-voltaic or PV module 1 comprising transparent glass support plate 2 carrying in this case thirty-five PV cells 3. The support plate 3 is usually indicated as superstrate. Usually, the backside of a PV cell 3 is the positive terminal (anode) and the top surface (the illuminated surface) is the negative terminal (cathode). In the example shown all PV cells 3 are connected in series and to this end the top of a cell 3 is connected to the bottom of the next cell by two connection strips 4 as can be seen in Figs. 1, 3 and 4. It is noted that the construction of the PV module 1 is not part of the present invention so that this construction is not described in further detail.

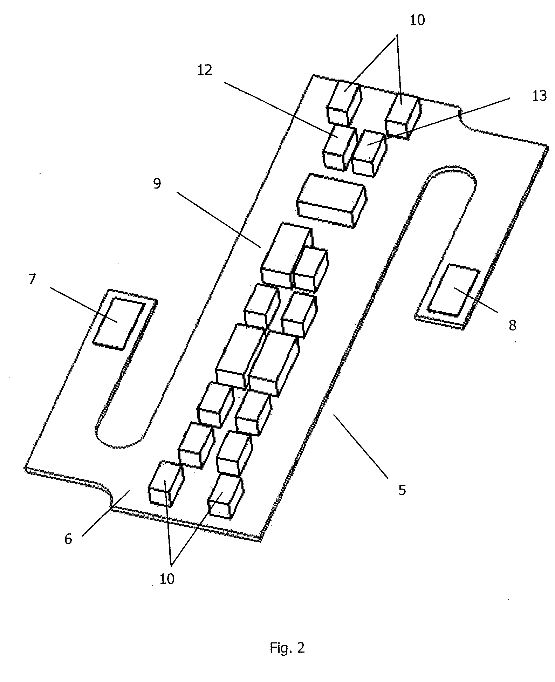

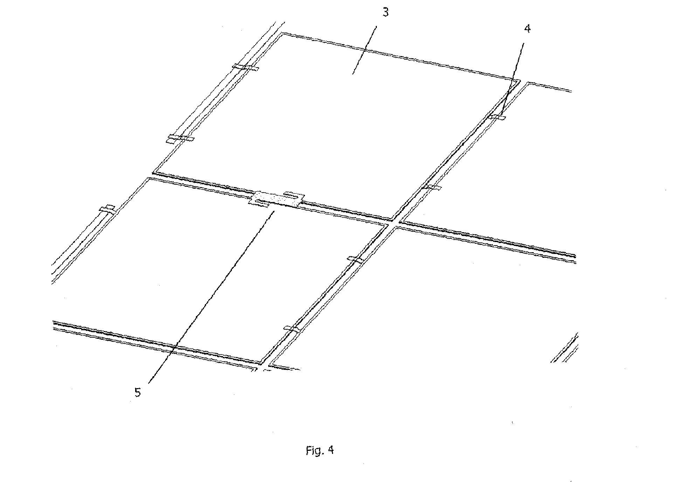

The PV module 1 is provided with a sensor device 5 for monitoring the operation of the PV module 1. In the embodiment of Fig. 1, the sensor device 5 is mounted on the support plate 2 between two adjacent PV cells 3. As shown in Fig. 2, the sensor device 5 comprises a substrate 6 with two input terminals 7,8 for receiving an output voltage of a series connection of PV cells 3. As can be seen in Fig. 4, the input terminals 7,8 are connected to the backside of the adjacent cells 3 at the top of the PV module 1 so that the input terminals 7,8 will receive the output voltage of thirteen cells 3 in series (the seven most left cells 3 and six cells 3 of the next column of cells).

The substrate 6 is provided with electronic circuitry 9 which will be described in more detail later. Further the substrate is provided with four positioning parts 10 located at the corners of the substrate 6 to position the substrate between the PV cells 3.

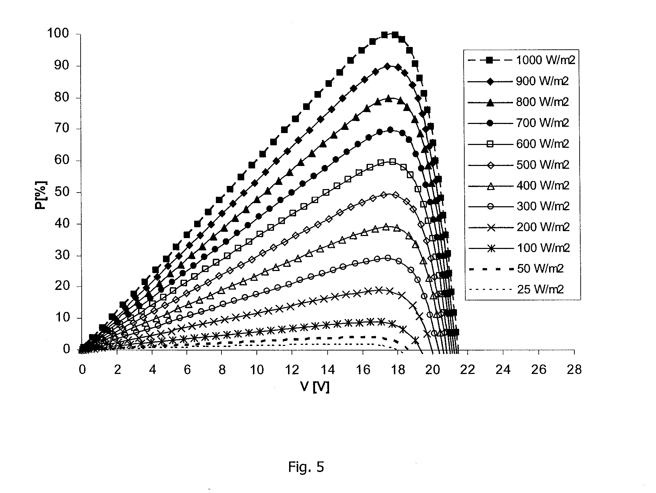

To explain the operation of the sensor device 5, reference is made to Figs. 5-8. As noted, the PV module 1 consists of a series connection of PV cells 3 as is usual for PV modules. During production of PV cells, each cell is tested and the cells are binned, i.e. matched in groups. Within one PV module only cells of the same bin are used. To obtain the maximum power from a PV module, the module must be loaded at the proper voltage, the so-called maximum power point voltage Vₘₚₚ. For an equally illuminated PV module consisting of more or less identical PV cells connected in series, it can be shown that the maximum power point voltage is dependent on two factors, i.e. the temperature of the cells and the irradiation of the cells.

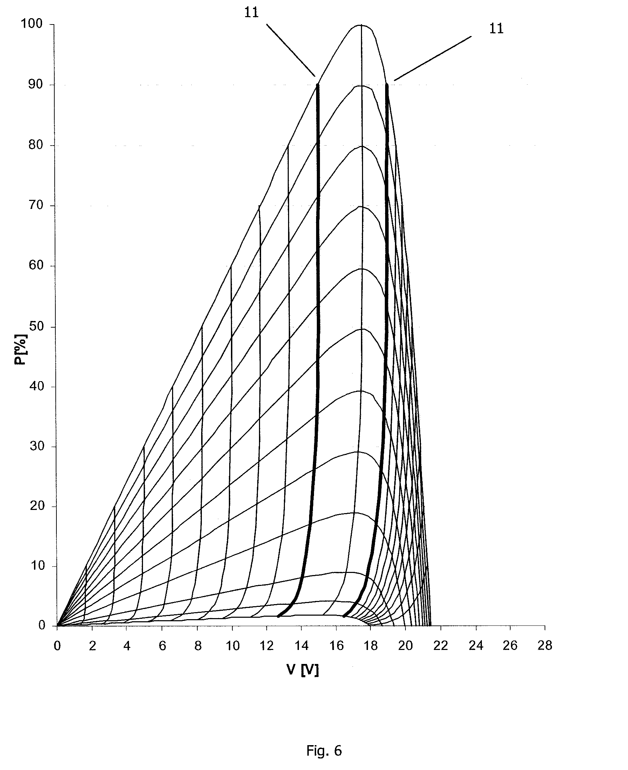

Fig. 5 shows a power versus voltage graph at different illuminations of a PV module at a cell temperature of 25°C. This graph clearly shows at which voltage the module should be loaded to obtain the maximum power at a certain irradiation. The same graph is shown in Fig. 6, wherein mainly vertically extending lines are added which interconnect points of equal maximum power point efficiency. These lines will be called the iso-efficiency lines. In the area between the bold iso-efficiency lines 11, the PV module delivers more than 90% of the available power. In the areas to the right and left of the bold iso-efficiency lines 11, the PV module delivers less than 90% of the available power. It is noted that Fig. 6 is valid at a cell temperature of 25°C.

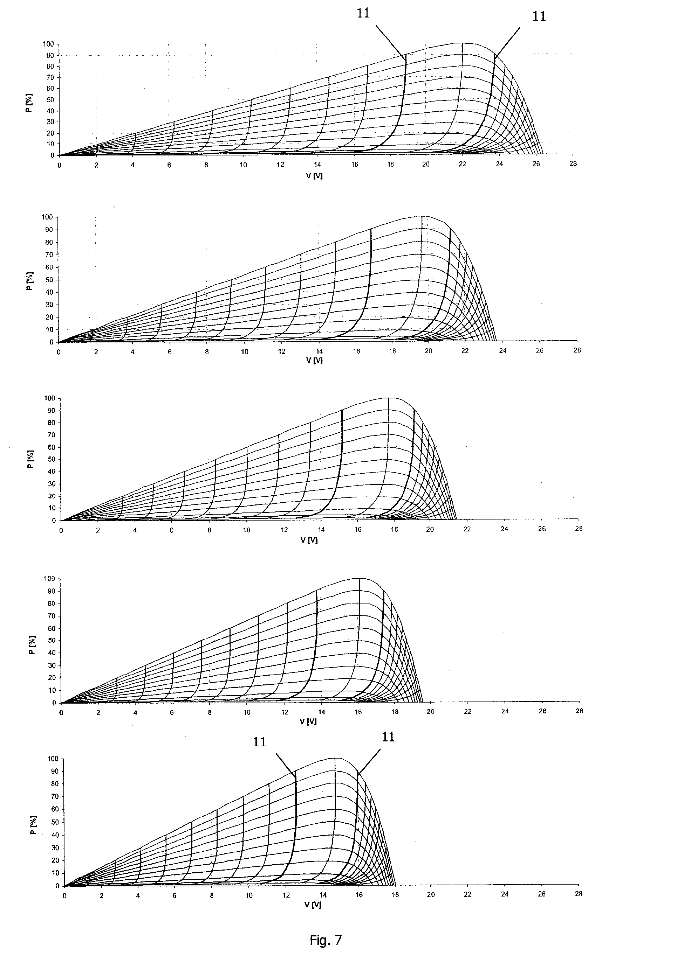

The temperature dependency of the power versus voltage graph is shown in Fig. 7. Fig. 7 shows from the top to the lower side five power versus voltage graphs at temperatures of -25°C, 0°C, 25°C, 50°C and 75°C, respectively. As can be seen in Fig. 7, there is a significant temperature dependency of the power versus voltage graph. The bold iso-efficiency lines 11 are shown in the graphs of Fig. 7 indicating that the left side 90% iso-efficiency line is located around 18 V at a temperature of - 25°C, whereas at a temperature of +25°C, the right side 90% iso-efficiency line is located around 18 V.

From the power versus voltage graph of Fig. 6, it can be seen that the operation of the PV module 1 in the 90% power range can be monitored by the sensor device 5 by means of a comparator comparing the output voltage of the series connection of the PV cells 3 received on the input terminals 7,8 with at least a first reference voltage corresponding with the left 90% iso-efficiency line shown in Fig. 6. The comparator controls a first signalling element, which is provided as a green LED 12 (see Fig. 2) visually signalling the operation above the left 90% iso-efficiency line 11. The comparator is further preferably operable to compare the output voltage with a second reference voltage corresponding with the right iso-efficiency line 11 in Fig. 6. If the output voltage exceeds above this second reference voltage, the LED 12 should be switched off and in the embodiment shown a red LED 13 is switched on to signal the operation of the PV module 1 above the right 90% efficiency line 11. Of course other manners of operating the LED(s) are possible, such as intermittent operation or the like. It is also possible to use acoustic signalling alone or in combination with visual signalling either on the PV module or on a remote device.

Although the sensor device 5 could measure the voltage output of all cells 3 in the PV module 1, it is also possible when all cells 3 are substantially identical to measure the voltage of only one cell as this would give the same information. Both options are however not optimal as the cells are matched, but are not exactly the same. By measuring the voltage across a series connection of cells, the standard deviation is reduced with the square route of the number of cells. Measuring the voltage across all cells, could cause problems, when two or more modules are connected in parallel. If in such a case one module fails, the connection terminals of the malfunctioning module will feel the working voltage of the other module so that the sensor device of the malfunctioning module may not indicate the fault in case the sensor device would measure the voltage across all the cells in series. Moreover, as an electronic circuitry 9 is used in the sensor device 5 with LED's 12,13 as signalling elements, a low power dissipation of the sensor device can be obtained by using a low supply voltage just above the required minimum power voltage. A high power dissipation in the sensor device could easily affect the temperature of the sensor device.

In the embodiment shown, the sensor device 5 measures the voltage across a series connection of thirteen PV cells in series. In practice, the optimal number of cells is roughly between twelve to eighteen cells in series.

The electronic circuitry 9 comprises at least a temperature compensation element having a temperature coefficient corresponding to the temperature coefficient of the PV cells 3. Further, a irradiation compensation element can be added, said compensation device having the mainly the same spectral response as the PV cells 3. Examples of the compensation elements will be described hereinafter.

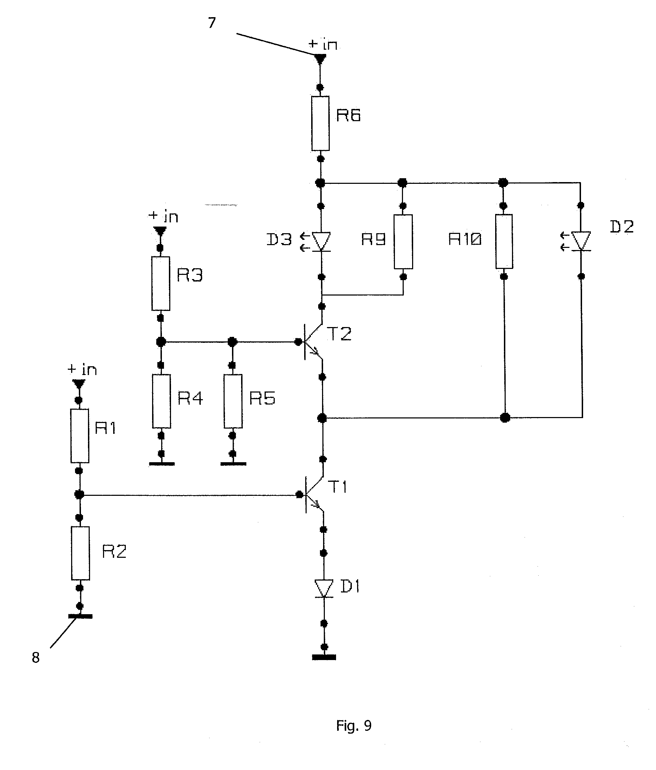

Fig. 9 shows a detailed circuit diagram of the electronic circuitry 9 of the sensor device 5, wherein the green LED 12 is represented by a first LED D₂ and the red LED 13 is represented by a second LED D₃. According to the embodiment of Fig. 9, the electronic circuitry comprises a first transistor T₁ operating as a comparator, and a temperature compensation element is provided as a first diode D₁ which is series connected to the emitter of transistor T₁. The connection of input terminals 7 (positive input) and 8 (negative input) are also shown in Fig. 9. By means of the voltage divider R₁, R₂ a part of the output voltage of the PV cells 3 is applied to the series connection of two pn-junctions, the base-emitter junction of T₁ and D₁. These pn-junctions of T₁ and D₁ provide the first reference voltage. If the output voltage increases slowly from zero, current will be injected in the base of transistor T₁ when the supply voltage is high enough. This will cause a collector current through T₁ and when this current is high enough a current will flow through LED D₂. This means that the green LED 12 will light up signalling the operation of the PV module 1 above the left 90% iso-efficiency line 11 in Fig. 6.

The electronic circuitry 9 comprises a second transistor T₂ for providing the second reference voltage level. When the supply voltage increases further, the voltage at the base of second transistor T₂ received from a second voltage divider R₃, R₄, R₅ will become high enough to inject current in the base of T₂. By that time T₁ will be fully saturated. Since the forward voltage of the red LED D₃ is much lower than the forward voltage of the green LED D₂, the current through D₂ will move to D₃, resulting in switching off of the green LED 12 and switching on of the red LED 13. This signals operation of the PV module 1 above the right iso-efficiency line 11.

The voltage levels at which the LED's are switched on and off is determined by the ratio of the voltage dividers at the base of both transistors T₁, T₂ and the sum of the base to emitter voltage and the forward voltage of D₁. In the embodiment shown diode D₁ is a Schottky diode with a forward voltage of approximately 0.3 V. The base to emitter voltage is approximately 0.7 V, so that the starting point for the green LED D₁₂ is around 1 V. Since this voltage is built up across two pn-junctions the temperature coefficient is approximately -4mV/K. This is -0.4%/K and matches the voltage temperature coefficient of the PV module 1.

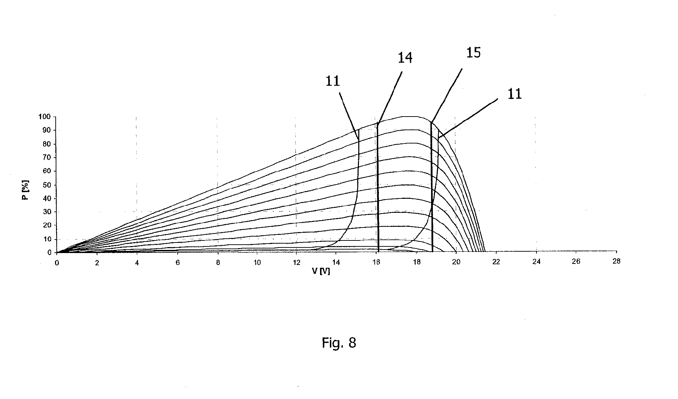

In the embodiment of Fig. 9, only a compensation for the temperature is provided by means of pn-junctions of T₁ and D₁. There is no compensation for solar irradiation dependency. This results in straight "iso-efficiency" lines 14,15 as shown in Fig. 8 which provides an acceptable approximation of the optimal area of operation of the PV module.

From the description of the embodiment of Fig. 9 it will be clear that temperature compensation is provided in an easy manner by means of silicon pn-junctions. A silicon pn-junction shows more or less the same temperature coefficient as PV silicon cells. If other types of PV cells are used, the operation point of diode D₁ can be changed or circuit elements can be added to obtain a temperature coefficient corresponding to the type PV cell used or a diode of the same type of material can be used.

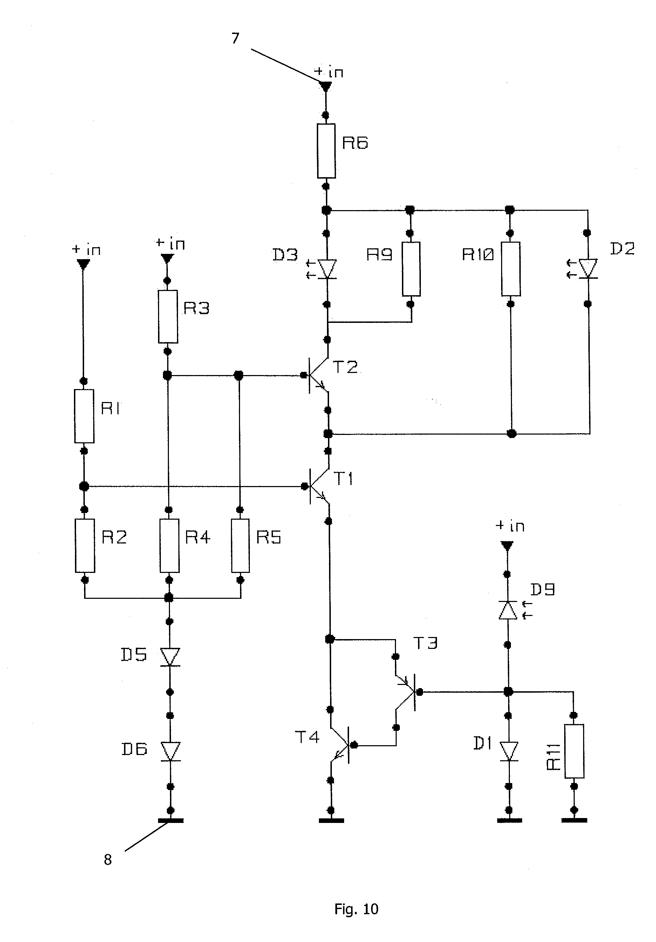

The same applies to the sensitivity of PV cells for sunlight. The electronic circuitry of Fig. 9 can be modified in an easy manner to provide a solar irradiation compensation element so that the iso-efficiency lines 11 will be followed in an accurate manner. Such a modified embodiment is shown in Fig. 10.

In this embodiment a photo diode D₉ is added and the photo current of D₉ flows through the temperature compensation diode D₁. As the photo current of the photo diode D₉ is orders of magnitude lower than the emitter current of transistor T₁, the forward voltage will be approximately 0.5 V. A resistor R₁₁ is connected parallel to the diode D₁ to simulate the shunt resistance of the PV cells. The spectral response of the diode D9 corresponds to the spectral response of the PV cells 3. In this manner the voltage at junction 16, i.e. the anode of diode D₁, will show the same relative behaviour as the maximum power point voltage of the PV module 1.

A transistor pair T₃, T₄ is provided to convert the voltage at the anode of D₁ to a low impedance at the emitter of T₃. As the use of T₃ also adds a voltage of one pn-junction to the voltage at the anode of D₁, the voltage at the base of transistor T₁ must be approximately 0.5 V, the forward voltage of D₁, plus the voltage of two pn-junctions. This required voltage at the base of T₁ is built up by the voltage divider R₁, R₂ plus the forward voltage across two further diodes D₅ and D₆. These diodes are provided to compensate the voltage across the base to emitter junctions of T₁ and T₃. This means that the starting point of LED D₂ is mainly controlled by the voltage of D₁. As mentioned above, this voltage is approximately 0.5 V with a temperature coefficient of -2mV/k or -0.4%/K, which matches the temperature coefficient of a PV module.

From the above description it will be clear that the invention provides a low cost sensor device by means of which the operation of a PV system can be monitored by a visual check not requiring any expertise. The green LED 12 lighting up indicates operation of the PV module between the iso-efficiency lines 11. If the red LED 13 lights up, the PV module operates above the right iso-efficiency line 11, whereas if no LED lights up, the PV module operates below the left iso-efficiency line 11 or its dark or nearly dark.

It is noted that the above mentioned colours of the LED's are mentioned by way of example only. For example, a blue LED can be used in stead of a green LED. Further, the embodiments of figs. 9 and 10 can be changed by omitting the LED 13, so that only a visual indication of operation in the optimal operating range is provided. Moreover, further operation levels could be added, such as 70 % and 80 % by adding further signalling elements and reference levels. Although more or less discrete circuit elements are shown in Fig. 2, 9 and 10, it will be clear that integrated circuits can be used or circuits obtained by any other method of manufacturing.

The invention is not restricted to the above-described embodiments which can be varied in a number of ways within the scope of the claims.

## Claims

1. Sensor device (5) for monitoring the operation of a PV system, said PV system having at least one PV module (1) with a plurality of PV cells (3) laminated on a support plate (2), **characterized by** a substrate with an electronic circuitry (9) adapted to be mounted on the support plate adjacent to PV cells of the PV module, said circuitry comprising two or more input terminals (7,8) for receiving an output voltage of a series connection of one or more PV cells of a PV module, and a comparator (T₁,T₂) for comparing the output voltage received on the input terminals with a first reference voltage corresponding with a first operation level of the PV module, the comparator controlling a first signalling element (12) for signalling the operation of the PV module above said first operation level.

2. Sensor device according to claim 1, wherein said comparator (T₁,T₂) is operable to compare the output voltage received on the input terminals with a second reference voltage corresponding with a second operation level of the PV module (1), wherein the comparator is controlling a second signalling element (13) for signalling operation of the PV module above said second operation level.

3. Sensor device according to claim 1 or 2, wherein the comparator comprises a temperature compensation element (T₁,D₁) operable to vary the reference voltage(s) in dependence on the temperature of the PV module (1), wherein the temperature coefficient of the temperature compensation element corresponds to the temperature coefficient of the PV cells (3).

4. Sensor device according to claim 1, 2 or 3, wherein the comparator (T₁,T₂) comprises a solar irradiation compensation element (D₉) operable to vary the reference voltage in dependence on the solar radiation of the PV module (1), wherein the spectral response of the solar irradiation compensation element corresponds with the spectral response of the PV cells (3).

5. Sensor device according to claim 3 or 4, wherein the comparator (T₁,T₂) comprises a semiconductor element (T₁,D₁), preferably a semiconductor element of the same type as the PV cells (3), with a pn-junction determining the first reference voltage, wherein said pn-junction also operates as said temperature compensation element.

6. Sensor device according to claim 5, wherein the comparator comprises a light sensitive photo element (D₉), wherein the photo current of the photo element flows through the pn-junction of the semiconductor element (D₁).

7. Sensor device according to claim 5 or 6, wherein the electronic circuitry comprises a first transistor (T₁), a first diode (D₁), preferably a Schottky diode, connected to the emitter of the first transistor, a first voltage divider (R₁,R₂) having its tap connected to the base of the first transistor, and a first LED (D₂) connected as first signalling element (12) to the collector of the first transistor, wherein the series connection of the first LED, the c-e section of the first transistor and the first diode, and the voltage divider are connected to the input terminals of the electronic circuitry.

8. Sensor device according to claim 7, wherein a second transistor (T₂) and a second LED (D₃) connected as second signalling element (13) to the collector of the second transistor, are connected parallel to the first LED (D₁), wherein a second voltage divider (R₃,R_{4,5}) is provided having its tap connected to the base of the second transistor, wherein the tap voltage of the second voltage divider (R₃,R_{4,5}) lies at a higher level as the tap voltage of the first voltage divider (R₁,R₂), wherein the forward voltage of the second LED is lower than the forward voltage of the first LED.

9. Sensor device according to claims 6 and 7, wherein said photo element is a photo diode (D₉) connected in series with the first diode (D₁), wherein preferably a resistor (R₁₁) simulating the shunt resistance of a series of PV cells (3) is connected parallel to the first diode, wherein the junction of the photo diode and the first diode is coupled to the emitter of the first transistor (T₁) through a transistor pair (T₃,T₄).

10. Sensor device according to any one of the preceding claims, wherein the substrate (2) of the electronic circuitry (9) is provided with extensions carrying the input terminals (7,8) adapted to be connected to the back side of adjacent cells (3).

11. Sensor according to any one of the preceding claims, wherein the substrate (9) of the electronic circuitry (9) is provided with positioning parts (10) for positioning the substrate between PV cells (3).

12. PV system, comprising at least one PV module (1) with a number of series connected PV cells (3), **characterized in that** said at least one PV module is provided with a sensor device (5) according to any one of the preceding claims.

13. PV system according to claim 12, wherein the input terminals (7,8) of the electronic circuitry (9) are connected to a series connection of only a part of all PV cells (3) of the module (1), for example a series of 12 - 18 PV cells.
